Europäisches Patentamt
European Patent Office
Office européen des brevets

(19)

(11) Numéro de publication: **0 048 655**

**A1**

# (12) DEMANDE DE BREVET EUROPEEN

(21) Numéro de dépôt: **81401397.5**

(22) Date de dépôt: **08.09.81**

(51) Int. Cl.³: **H 05 B 33/08**

(30) Priorité: **18.09.80 FR 8020377**

(43) Date de publication de la demande:
**31.03.82 Bulletin 82/13**

(84) Etats contractants désignés:
**BE GB IT LU NL SE**

(71) Demandeur: **Sauvel, François**
**18 avenue Soyer**
**F-78400 Chatou(FR)**

(72) Inventeur: **Sauvel, François**
**18 avenue Soyer**
**F-78400 Chatou(FR)**

(74) Mandataire: **Marquer, Francis et al,**
**CABINET MOUTARD 35, avenue Victor Hugo Résidence**
**Chamfleury**
**F-78190 Voisins le Bretonneux(FR)**

(54) Dispositif d'alimentation d'un voyant lumineux de contrôle de courant.

(57) Dispositif d'alimentation d'un voyant lumineux de contrôle de courant, comportant une source de tension alternative ou continue (V) débitant un courant dans un circuit comportant l'utilisation d'une résistance (R) caractérisé par un ensemble de composants semi-conducteurs (1 - 2 - 3) montés en série dans ledit circuit et aptes à fournir à leurs bornes une chute de tension sensiblement constante, ledit voyant (6) étant monté en parallèle sur ledit ensemble.

Application à l'alimentation des voyants à diode émettrice de lumière.

Fig.1

EP 0 048 655 A1

- 1 -

## Dispositif d'alimentation d'un voyant lumineux de contrôle de courant

L'invention se rapporte aux voyants lumineux utilisés pour signaler le fonctionnement d'un appareil électrique.

Les voyants les plus fréquemment utilisés actuellement sont constitués par une lampe à incandescence généralement alimentée en tension par un circuit distinct de celui de la charge.

On utilise toutefois, de plus en plus fréquemment, des diodes émettrices de lumière, qui présentent l'avantage d'une meilleure résistance aux vibrations et d'une durée de vie extrêmement grande, mais doivent être alimentées en courant, avec des intensités comprises entre 10 et 100 mA, suivant le modèle de diode utilisé. La solution qui consiste à alimenter ces diodes à partir du réseau alternatif, par l'intermédiaire d'un transformateur de courant, est relativement onéreuse.

La présente invention propose de monter le voyant en série avec la charge elle-même ou, lorsque la tension d'alimentation est relativement basse, en série avec une charge auxiliaire, et se caractérise par le fait que le voyant est alimenté à partir de la chute de tension aux bornes d'un ensemble de composants semi-conducteurs montés en série et procurant une chute de tension pratiquement constante, quels que soient la tension d'alimentation et le courant dans la charge. Il s'agit avantageusement de diodes au silicium.

Dans un mode d'exécution préféré, où le voyant est constitué par une diode émettrice de lumière, celle-ci est reliée en série avec une résistance de valeur appropriée, l'ensemble étant monté en parallèle sur ledit ensemble de diodes en série et des moyens étant prévus pour empêcher la génération d'une tension inverse aux bornes de la diode émettrice de lumière.

Les diverses particularités, ainsi que les avantages de l'invention, apparaîtront clairement à la lumière de la description ci-après.

Au dessin annexé :

La figure 1 est le schéma électrique d'un dispositif d'alimentation d'un voyant à diode émettrice de lumière, conforme à un mode d'exécution préféré de l'invention ;

La figure 2 est le schéma électrique d'un dispositif d'alimentation d'un voyant comportant une lampe à incandescence.

La figure 3 est le schéma d'une diode électroluminescente à laquelle est associé un circuit imprimé comportant les composants d'un dispositif d'alimentation conforme à l'invention, et

La figure 4 représente le schéma d'un dispositif d'alimentation comportant deux diodes électro-luminescentes.

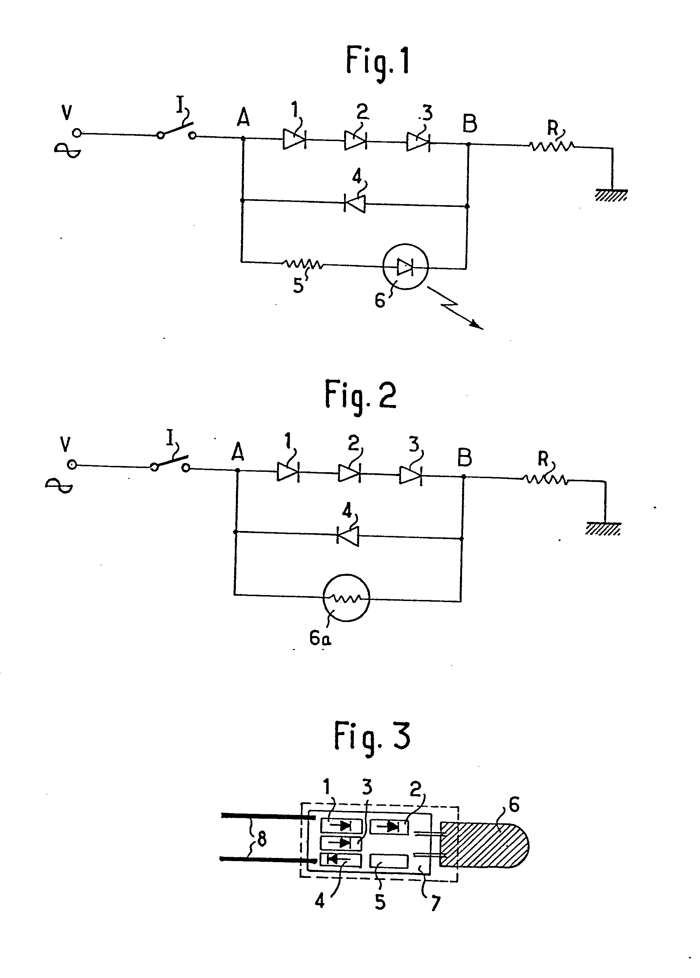

A la figure 1, on a représenté trois diodes au silicium 1 - 2 - 3, montées en série et, en parallèle sur cet ensemble, d'une part une diode 4 montée en sens inverse et, d'autre part, l'ensemble constitué par une résistance 5 en série avec une diode électro-luminescente 6. Le montage ainsi constitué est alimenté par une tension alternative V et connecté en série avec une charge d'utilisation R. Un interrupteur I permet la mise en service du montage.

A titre d'exemple, la tension V est le secteur à 220 V, les trois diodes 1 - 2 - 3 représentent une chute de tension totale de l'ordre de 2,5 V. (valeur de crête). Cette dernière est pratiquement indépendante des variations importantes que peut subir le courant dans la charge R. La résistance 5 faisant par exemple 20 Ω, et la chute de tension dans la diode émettrice de lumière étant, par exemple, lorsqu'elle est soumise à un courant normal de commande, de l'ordre de 1,8 V., il en résulte que la valeur de crête du courant qui circule dans l'ensemble 5 - 6 sera alors égale à $\frac{2,5 - 1,8}{20}$ A, soit : 35 mA.

La majeure partie du courant qui circule dans la charge (de l'ordre de 1A, par exemple) passera alors dans les trois diodes 1 - 3, la résistance 5 servant en définitive à fixer l'intensité de courant de commande, relativement faible, nécessaire à la diode émettrice de lumière.

La diode 4 sert à empêcher la génération d'une tension inverse aux bornes de la diode émettrice de lumière. Elle ne sera évidemment pas nécessaire si la tension d'alimentation est continue. Dans certains cas, plusieurs diodes en série, montées en sens inverse des diodes 1 - 3, pourront être utilisées. Par ailleurs, les deux ensembles série de base, constitués par les diodes 1 - 2 - 3 d'une part, la résistance 5 et la diode électro-luminescente 6 d'autre part, pourraient faire partie d'un pont, ou de tout autre montage agencé pour qu'aucune tension inverse ne puisse se manifester aux bornes de la diode émettrice de lumière.

A la figure 2, le voyant est constitué par une lampe à incandescence à basse tension 6 a. Dans ce cas, la résistance 5 devient inutile, la lampe pouvant être alimentée en tension. On pourra remplacer la diode 4 par un ensemble de trois diodes montées en série, en sens inverse de l'ensemble 1 - 2 - 3, de façon à réaliser un montage symétrique : la lampe sera alors alimentée sur les deux alternances.

Bien entendu, dans les montages des figures 1 et 2, le nombre des diodes 1 - 2 - 3 devra être choisi en fonction de la chute de tension totale nécessaire pour que l'alimentation du voyant s'effectue correctement.

On notera que les montages décrits n'exigent pas que le voyant soit adapté au courant nominal qui circule dans la charge et ce, pour une large gamme de courants, et qu'ils autorisent des variations importantes de ce courant en cours de fonctionnement (marche à demi-régime ou vide par exemple). L'alimentation est possible dans une large gamme de tension.

La coupure du filament ou la détérioration de la diode émettrice de lumière n'empêche pas le fonctionnement de l'appareil contrôlé. Par ailleurs, le montage du voyant est très facile à effectuer et très peu onéreux.

L'ensemble des diodes 1 à 4 et la résistance 5 sera avantageusement monté sur un petit circuit imprimé 7 (figure 3), éventuellement lié mécaniquement à l'ampoule ou à la diode émettrice de lumière 6 et muni des deux fils d'alimentation 8.

Dans le cas d'une basse tension d'alimentation, la dissipation d'énergie étant moins importante qu'en haute tension, elle pourrait s'effectuer dans une résistance auxiliaire en série avec le montage.

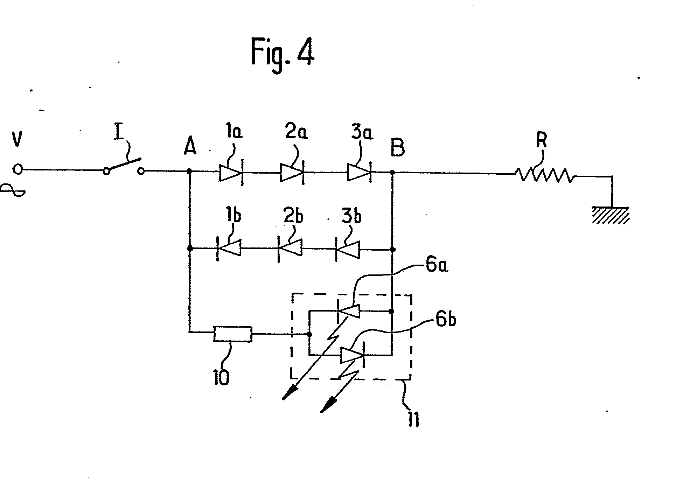

Dans le dispositif de la figure 4, deux ensembles comportant chacun trois diodes en série, 1a - 2a - 3a et 1b - 2b - 3b respectivement, sont disposés en parallèle entre les points A et B. Les diodes du premier ensemble sont montées tête-bêche par rapport à celles du second. Deux diodes électroluminescentes 6a et 6b sont montées en parallèle et tête-bêche, en série avec une résistance 10 entre les points A et B. On obtient ainsi l'éclairement à chaque alternance de la tension d'alimentation V. Les deux diodes électro-luminescentes sont avantageusement placées dans une même capsule transparente 11.

Dans les montages des figures 1 et 4, il est possible d'utiliser à la place de chaque diode électro-luminescente, deux ou plusieurs diodes électro-luminescentes montées en série, à condition de prévoir que chaque ensemble de diodes en série (1-2-3, 1a-2a-3a ou 1b-2b-3b) comportera un nombre de diodes supérieur à trois, engendrant la chute de tension appropriée entre les points A et B. La résistance 5 ou 10 devra alors être adaptée au courant requis pour obtenir l'éclairement désiré.

Revendications de brevet.

1. Dispositif d'alimentation d'un voyant lumineux de contrôle de courant, comportant une source de tension alternative ou continue (V) débitant un courant dans un circuit comportant l'utilisation d'une résistance (R), caractérisé par un ensemble de composants semi-conducteurs (1 - 2 - 3) montés en série dans ledit circuit et aptes à fournir à leurs bornes une chute de tension sensiblement constante, ledit voyant (6) étant monté, en parallèle sur ledit ensemble.

2. Dispositif d'alimentation selon la revendication 1, caractérisé en ce que lesdits composants (1, 2, 3) sont des diodes au silicium.

3. Dispositif d'alimentation selon la revendication 1 ou 2, dans lequel ladite source est alternative, caractérisé par des moyens d'empêcher la génération d'une tension inverse aux bornes dudit ensemble.

4. Dispositif selon la revendication 3, caractérisé en ce que lesdits moyens sont constitués par une diode (4) montée tête-bêche par rapport auxdits composants (1 - 2 - 3).

5. Dispositif selon l'une des revendications 1 à 4, dans lequel ledit voyant comprend une diode émettrice de lumière (6), caractérisé par une résistance (5) montée en série avec ladite diode émettrice de lumière (6).

6. Dispositif selon la revendication 1, 2 ou 5, caractérisé par deux ensembles de composants semi-conducteurs (1a - 2a - 3a et 1b - 2b - 3b), montés en parallèle et tête-bêche et par deux voyants (6a - 6b) montés en parallèle et tête-bêche.

Fig.1

Fig. 2

Fig. 3

Fig. 4

**0048655**
Numéro de la demande

Office européen
des brevets

**RAPPORT DE RECHERCHE EUROPEENNE**

EP 81 40 1397

| | DOCUMENTS CONSIDERES COMME PERTINENTS | | CLASSEMENT DE LA DEMANDE (Int. Cl.³) |
|---|---|---|---|
| Catégorie | Citation du document avec indication, en cas de besoin, des parties pertinentes | Revendication concernée | |
| | <u>US - A - 4 190 830</u> (BELL)<br>* Lignes 40-61; figure 2 *<br><br>--<br><br>Q.S.T. AMATEUR RADIO, vol. 57,<br>no. 2,février 1973<br>Newington, US<br>W.J. STILES "A Constant Voltage<br>Divider", pages 22,23<br>* Page 22, paragraphe "Circuit<br>information"; figure 2 *<br><br>-- | 1<br><br><br>1,2 | H 05 B 33/08 |
| A | <u>FR - A - 2 350 034</u> (GAILLARD)<br>* Revendications; figure<br>unique *<br><br>---- | 1 | **DOMAINES TECHNIQUES RECHERCHES (Int. Cl.³)**<br><br>H 05 B 33/08<br>G 05 F 1/16 |
| | | | **CATEGORIE DES DOCUMENTS CITES**<br><br>X: particulièrement pertinent<br>A: arrière-plan technologique<br>O: divulgation non-écrite<br>P: document intercalaire<br>T: théorie ou principe à la base de l'invention<br>E: demande faisant interférence<br>D: document cité dans la demande<br>L: document cité pour d'autres raisons<br><br>&: membre de la même famille, document correspondant |

Le présent rapport de recherche a été établi pour toutes les revendications

| Lieu de la recherche | Date d'achèvement de la recherche | Examinateur |
|---|---|---|
| La Haye | 18-12-1981 | DUCHEYNE |

OEB Form 1503.1 06.78